# EUROPEAN PATENT SPECIFICATION

(11) **EP 0 432 895 B1**
(45) Date of publication and mention of the grant of the patent: **27.09.1995**
(21) Application number: 90312274.5
(22) Date of filing: 09.11.1990
(51) Int. Cl.: H03H 11/22

(54) **Phase splitter arrangement**
Phasenteileranordnung
Diviseur de phase

(30) Priority: 15.12.1989 GB 8928377
(43) Date of publication of application: 19.06.1991
(73) Proprietor: NORTHERN TELECOM LIMITED, Montreal, Quebec H2Y 3Y4 (CA)
(72) Inventor: Rokos, George Hedley Storm, Bishop's Stortford, Herts CM23 3JH (GB)
(74) Representative: Dennis, Mark Charles

(56) References cited:
- US-A- 2 984 799
- US-A- 3 976 958

## Description

This invention relates to arrangements for forming phase quadrature components of r.f. signals.

One type of radio receiver is that known as 'zero IF' or 'direct conversion', in which the received r.f. signals are mixed with local oscillator signals substantially at the carrier frequency to produce baseband signals which represent quadrature components of the received r.f. signal, as disclosed in British patent 1517121.

A requirement of this type of receiver is that at least the incoming r.f. or the local oscillator r.f. signal must be put through a phase splitter arrangement to obtain phase quadrature components. It is a further requirement for efficient operation of the receiver that the quadrature components have accurate orthogonality and balanced amplitudes.

Known forms of phase splitting arrangements include widely used RC/CR networks, also known as phase lead/lag networks. One problem with such networks is that it is difficult to obtain identical output amplitudes. In practice it is necessary to follow the RC/CR networks with correcting amplifiers, e.g. limiting or AGC amplifiers, to provide equal output amplitudes from the two quadrature phase components. However the effect of such amplitude correcting amplifiers is to introduce phase errors into the quadrature components.

According to the present invention there is provided an arrangement for improving the accuracy of phase quadrature signals comprising means for generating from initial quadrature signals respective signals having substantially equal amplitude and for obtaining sum and difference signals of said equal amplitude signals, and output means for rendering substantially equal the amplitudes of the sum and difference resultant signals.

Embodiments of the invention will now be described with reference to the accompanying drawings which is a schematic circuit of a combined r.f. phase splitter and amplifier arrangement for producing phase quadrature components of a local oscillator r.f. signal.

A voltage controlled oscillator (VCO) feeds a first RC network comprised of resistors R₁, R₂ and capacitor C₁, to form a first pair of balanced r.f. input signals. The VCO also feeds a second CR network comprised of capacitors C₂, C₃ and resistor to R₃ to form a second pair of balanced r.f. input signals which are effectively in quadrature phase relationship with the first pair. Although the phases of the signals of each pair will be substantially orthogonal the amplitudes of the signals in one pair will be greater than those of the other pair. The pairs of input signals are referenced Iᵢ, I̅ᵢ, Qᵢ and Q̅ᵢ respectively. Pairs of transistors T₁, T₂, T₃ ... T₈ form balanced limiting amplifiers. Signals Iᵢ and Q̅ᵢ are applied to T₁ and T₂ respectively. Signals I̅ᵢ and Qᵢ are applied to T₃ and T₄. Signals Iᵢ and Qᵢ are applied to T₅ and T₆ and signals I̅ᵢ and Q̅ᵢ are applied to T₇ and T₈ respectively. The arrangement is such that sum and difference outputs, which have inherently accurate 90° phase differences, are produced. The sum and difference output signals Iₒ, I̅ₒ and Qₒ, Q̅ₒ are then filtered and fed to conventional balanced limiting amplifiers formed by transistors T₉ - T₁₂.

Whilst the specific embodiment described above is with reference to the local oscillator signal, it is equally valid to form phase quadrature components of the incoming r.f. signal, or the output at baseband signal, instead of the local oscillator signal. In this case the use of a gain control system to match the amplitudes will often be more appropriate than a limiting amplifier.

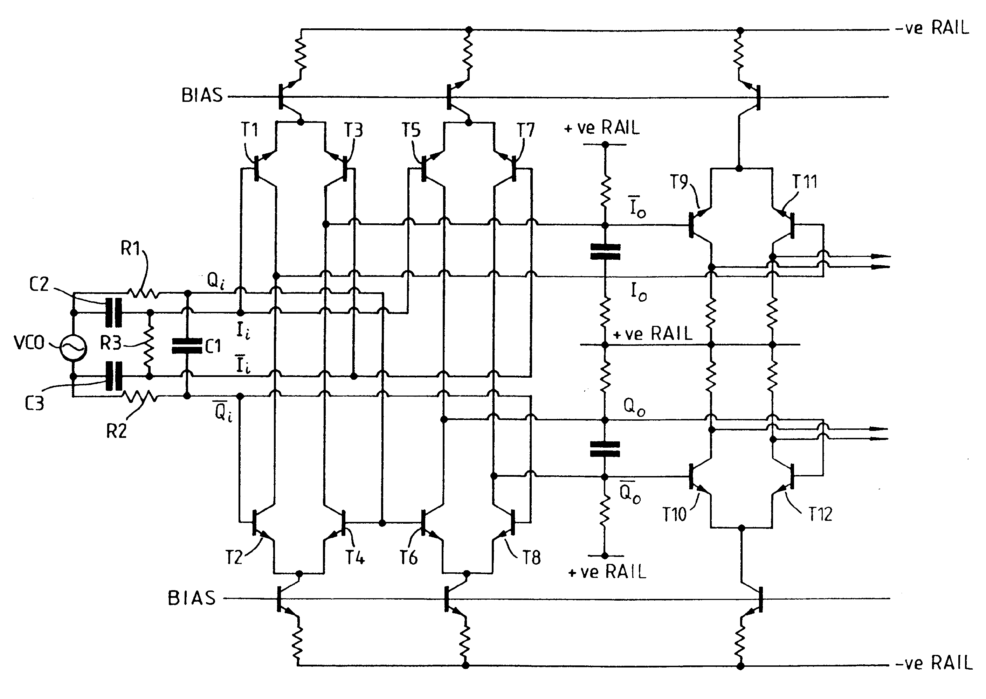

## Claims

1. An arrangement for improving the accuracy of phase quadrature signals characterised in that the arrangement includes means (T₁,T₂,T₃,T₄) for generating from initial quadrature signals (Iᵢ, I̅ᵢ, Qᵢ, Q̅ᵢ) respective signals having substantially equal amplitude and for obtaining sum and difference output signals (Iₒ, I̅ₒ, Qₒ, Q̅ₒ) of said equal amplitude signals, and output means (T₉-T₁₂) for rendering substantially equal the amplitudes of the sum and difference resultant signals.

2. An arrangement according to claim 1 wherein the initial quadrature signals are local oscillator (VCO) signals in a zero IF radio receiver.

3. An arrangement according to claim 1 wherein the initial quadrature signals are input r.f. signals in a zero IF radio receiver.

4. An arrangement according to claim 1 wherein the initial quadrature signals are baseband output signals from quadrature mixers in a zero IF radio receiver.

5. An arrangement according to any preceding claim wherein the means for rendering substantially equal the amplitudes of the sum and difference resultant signals comprises balanced limiting amplifiers (T₉-T₁₂).

6. An arrangement according to claim 4 wherein the means for rendering substantially equal the amplitudes of the sum and difference resultant signals comprises automatic gain control means.

## Patentansprüche

1. Anordnung zur Verbesserung der Genauigkeit von Phasenquadratursignalen, dadurch gekennzeichnet, daß die Anordnung Einrichtungen (T₁, T₂, T₃, T₄) zur Erzeugung jeweiliger Signale mit im wesentlichen gleicher Amplitude aus anfänglichen Quadratursignalen (Iᵢ, I̅ᵢ, Qᵢ, Q̅ᵢ) und zur Gewinnung von Summen- und Differenz-Ausgangssignalen (I₀, I̅₀, Q₀, Q̅₀) der eine gleiche Amplitude aufweisenden Signale und Ausgangseinrichtungen (T₉ - T₁₂) einschließt, um die Amplituden der resultierenden Summen- und Differenzsignale im wesentlichen gleich zu machen.

2. Anordnung nach Anspruch 1,
dadurch gekennzeichnet, daß die anfänglichen Quadratursignale Überlagerungsoszillator- (VCO-) Signale in einem Hochfrequenzempfänger mit einer Zwischenfrequenz von Null sind.

3. Anordnung nach Anspruch 1, bei der die anfänglichen Quadratursignale Hochfrequenz-Eingngssignale in einem Hochfrequenzempfänger mit einer Zwischenfrequenz von Null sind.

4. Anordnung nach Anspruch 1, bei der die anfänglichen Quadratursignale Basisband-Ausgangssignale von Quadraturmischern in einem Hochfrequenzempfänger mit einer Zwischenfrequenz von Null sind.

5. Anordnung nach einem der vorhergehenden Ansprüche, bei der die Einrichtungen, die die Amplituden der resultierenden Summen- und Differenzsignale im wesentlichen gleich machen, begrenzende Gegentaktverstärker (T₉ - T₁₂) sind.

6. Anordnung nach Anspruch 4, bei der die Einrichtungen, die die Amplituden der resultierenden Summen- und Differenz-Signale im wesentlichen gleich machen, automatische Verstärkungssteuereinrichtungen umfassen.

## Revendications

1. Ensemble destiné à accroître la précision de signaux en quadrature, caractérisé en ce que l'ensemble comporte un dispositif (T₁, T₂, T₃, T₄) destiné à créer, à partir de signaux initiaux en quadrature (Iᵢ, I̅ᵢ, Qᵢ, Q̅ᵢ), des signaux respectifs ayant des amplitudes pratiquement égales, et destiné à obtenir des signaux somme et différence de sortie (Iₒ, I̅ₒ, Qₒ, Q̅ₒ) à partir des signaux d'amplitudes égales, et un dispositif de sortie (T₉-T₁₂) destiné à rendre pratiquement égales les amplitudes des signaux résultants somme et différence.

2. Ensemble selon la revendication 1, dans lequel les signaux initiaux en quadrature sont des signaux d'un oscillateur local (VCO) incorporé à un récepteur radioélectrique à fréquence intermédiaire nulle.

3. Ensemble selon la revendication 1, dans lequel les signaux initiaux en quadrature sont des signaux d'entrée à hautes fréquences d'un récepteur radioélectrique à fréquence intermédiaire nulle.

4. Ensemble selon la revendication 1, dans lequel les signaux initiaux en quadrature sont des signaux de sortie en bande de base provenant de mélangeurs en quadrature dans un récepteur radioélectrique à fréquence intermédiaire nulle.

5. Ensemble selon l'une quelconque des revendications précédentes, dans lequel le dispositif destiné à rendre pratiquement égales les amplitudes des signaux résultants somme et différence comporte des amplificateurs limiteurs équilibrés (T₉-T₁₂).

6. Ensemble selon la revendication 4, dans lequel le dispositif destiné à rendre pratiquement égales les amplitudes des signaux résultants somme et différence comporte un dispositif de réglage automatique de gain.
